# EUROPEAN PATENT APPLICATION

(11) **EP 0 806 265 A1**
(43) Date of publication of application: **12.11.1997**
(21) Application number: 97302898.8
(22) Date of filing: 28.04.1997
(51) Int. Cl.: B24B 37/04

(54) **Precision polishing apparatus**

(30) Priority: 10.05.1996 JP 141077/96; 03.07.1996 JP 192815/96
(71) Applicant: CANON KABUSHIKI KAISHA, Tokyo (JP)
(72) Inventor: Takahashi, Kazuo, Ohta-ku, Tokyo (JP); Ban, Mikichi, Ohta-ku, Tokyo (JP); Nishimura, Matsuomi, Ohta-ku, Tokyo (JP)
(74) Representative: Beresford, Keith Denis Lewis

(57) **Abstract**

A precision polishing apparatus has a first hermetically sealed chamber (3) provided with polishing means (3al), a third hermetically sealed chamber (B) capable of communicating with the first hermetically sealed chamber through a second hermetically sealed chamber (2), first and second opening-closing means (20) for alternately communicating the first and the third hermetically sealed chamber (3,1) with the second hermetically sealed chamber, and atmosphere pressure control means for controlling the atmosphere pressure of the first and the second hermetically sealed chamber (2) so that the atmosphere pressure of the first hermetically sealed chamber (3) may become lower than the atmosphere pressure of the second hermetically sealed chamber (2) when at least the first opening-closing means (20) is opened.

## Description

This invention relates to a precision polishing apparatus for highly accurately polishing the surface or the like of a substrate such as a wafer on which dielectric material layers are laminated in a semiconductor device manufacturing process.

In recent years, the tendency of semiconductor devices toward a high degree of minuteness has advanced and the accuracy of the order of submicron has been required of the line width of minute patterns. Along with this, the technique of highly accurately flattening the surface of a substrate such as a wafer on which wiring or dielectric material layers are laminated has become necessary and a precision polishing apparatus adopting so-called mechano-chemical polishing or the like in which chemical reaction is concerned on a polished surface has been developed.

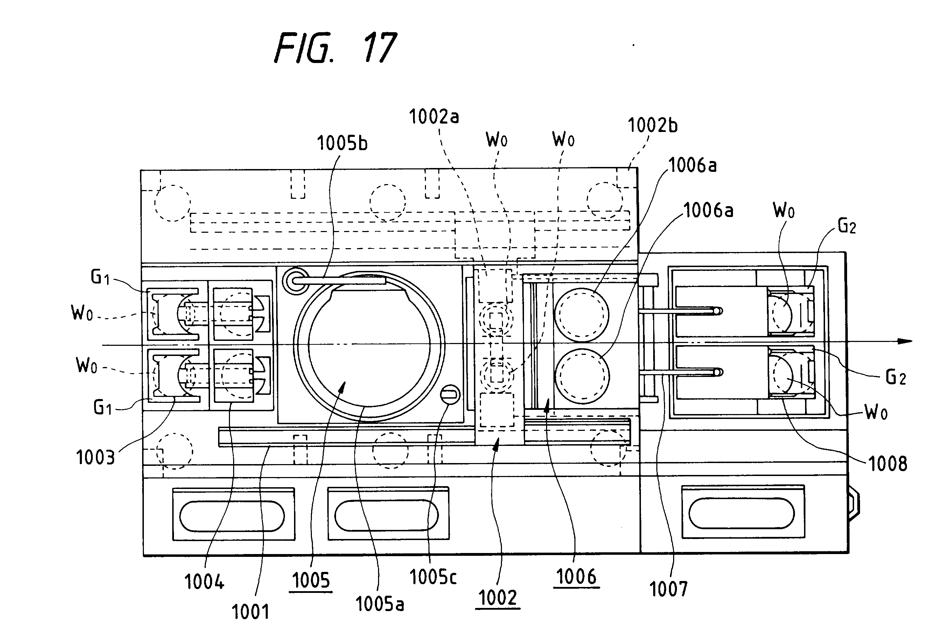

Referring to Fig. 17 of the accompanying drawings which shows a precision polishing apparatus the inventor designed prior to the present invention, this apparatus has a substrate holder 1002 for adsorbing and holding a pair of wafers W₀ in such a manner that the polished surfaces thereof face downward and conveying then along a guide 1001, loading portions 1003 disposed in series in the direction of conveyance of the wafers, a wafer centering portion 1004, a polishing portion 1005 for rotating a polishing pad 1005a on a stool, a wafer washing portion 1006, a wafer reversing portion 1007 and an unloading portion 1008.

Wafers W₀ contained in a loading cassette G₁ and carried in from the pre-process are taken out of the loading cassette G₁ in the loading portion 1003, and are subjected to centering in the wafer centering portion 1004, whereafter they are adsorbed by the substrate holder 1002 and conveyed to the polishing portion 1005. In the polishing portion 1005, the substrate holder 1002 is made to cross along the diameter of the polishing pad 1005a while each wafer W₀ is lightly urged against the surface of the polishing pad 1005a being rotated, thereby polishing the underside (the polished surface) of each wafer W₀. The substrate holder 1002 which as crossed the polishing pad 1005a is continuedly moved along the guide 1001 and arrives at the wafer washing portion 1006. Here, washing liquid is blown from a nozzle 1006a to the polished surface of each wafer W₀ to thereby remove the secondary product of polishing. The wafer reversing portion 1007 reverses the washed wafer W₀ and transports it to the unloading portion 1008. In the unloading portion 1008, the water W₀ is contained in an unloading cassette G₂ and sent out to the next step.

The substrate holder 1002 is suspended from a top frame 1002a movable above the wafer centering portion 1004, the polishing portion 1005, the wafer washing portion 1006, etc., and one end of the top from 1002a is supported from reciprocal movement along the guide 1001 and the other end thereof is connected to a driving portion 1002b. The top frame 1002a suspended from the substrate holder 1002 is reciprocally moved along the guide 1001 by the driving of the driving portion 1002b. The polishing portion 1005 is provided with a brushing device 1005b and a hand shower 1005c for cleaning the surface of the polishing pad 1005a. As described above, the apparatus is designed such that the polishing of the wafers W₀ continuously fed in from the pre-process and the subsequent washing step are automatically executed and the wafers are fed to the next step and the work of cleaning the surface of the polishing pad 1005a can be done efficiently which the substrate holder 1002 is moved in the opposite direction and returned from the unloading portion 1008 to the loading portion 1003.

According to the above-described technique, however, the series of steps of taking out the wafer carried in by a conveying device such as a conveyor out of the cassette, polishing the wafer and washing the polished surface thereof are automated to thereby greatly contribute to a reduction in the manufacturing cost of semiconductor devices or the like, but dust such as polishing powder created in the polishing portion enters the loading portion and the wafer washing portion adjoining the polishing portion and deteriorates the performance of the driving portion for these, and this leads to the problem of high cost which is left to be solved.

Also, an exposure apparatus or the like for wafer in the pre-process is generally operated under a cleaned atmosphere such as a clean room or the like and therefore, if the dust created in the polishing portion contaminates the atmosphere of the clean room, the performance of the exposure apparatus or the like may be remarkably spoiled. Further, is a great deal of polishing powder or the like enters the wafer washing portion together with the wafer taken out of the polishing portion, the quantity of washing liquid consumed will increase and the time spent for the washing of the wafer will also lengthen with a result that the manufacturing cost of semiconductor devices or the like will rise.

The present invention can provide a precision polishing apparatus in which dust such as polishing powder may not contaminate devices for effecting a pre-process and a post-process such as the centering and washing of a wafer and the atmosphere of a clean room in which these devices are disposed and moreover, the mechanism and control are simple and which is suitable for speedup and automation.

One aspect of the present invention provides a precision polishing apparatus provide a precision polishing apparatus having a first hermetically sealed chamber provided with polishing means, a third hermetically sealed chamber capable of communicating with the first hermetically sealed chamber through a second hermetically sealed chamber, first and second opening-closing means for alternately communicating the first and the third hermetically sealed chamber with the second hermetically sealed chamber, and atmosphere pressure control means for controlling the atmosphere pressure of the first and the second hermetically sealed chamber so that the atmosphere pressure of the first hermetically sealed chamber may become lower than the atmosphere pressure of the second hermetically sealed chamber when at least the first opening-closing means is opened.

Another aspect of the present invention provides a precision polishing method of polishing an object to be polished by precision polishing apparatus having a first hermetically sealed chamber provided with polishing means, a third hermetically sealed chamber capable of communicating with the first hermetically sealed chamber through a second hermetically sealed chamber, first and second opening-closing means for alternately communicating the first and the third hermetically sealed chamber with the second hermetically sealed chamber, and atmosphere pressure control means for controlling the atmosphere pressure of the first and the second hermetically sealed chamber so that the atmosphere pressure of the first hermetically sealed chamber may become lower than the atmosphere pressure of the second hermetically sealed chamber when at least the first opening-closing means is opened.

A further aspect of the present invention provides a precision polishing apparatus having a first hermetically sealed chamber provided with polishing means, a second hermetically sealed chamber, opening-closing means for communicating the first and the second hermetically sealed chamber with each other, and atmosphere pressure control means for controlling the atmosphere pressure of the first and the second hermetically sealed chamber so that the atmosphere pressure of the first hermetically sealed chamber may become lower than the atmosphere pressure of the second hermetically sealed chamber when the opening-closing means is opened, characterized in that the first hermetically sealed chamber has a downflow mechanism for blowing clean air downwardly from above.

A still further aspect of the present invention provides a precision polishing apparatus having a first unit for making an object to be polished wait temporarily, a second unit provided with polishing means for polishing the object to be polished transported from the first unit, a third unit for washing the object to be polished transported from the second unit, a fourth unit for drying the object to be polished transported from the third unit, hermetically sealing means for individually hermetically sealing the atmospheres of the first to fourth units, and atmosphere pressure control means for controlling the atmosphere pressure of each of the units to a value lower than the outside atmosphere pressure.

Yet another aspect of the present invention provides a precision polishing apparatus having a first hermetically sealed chamber provided with polishing means for polishing an object to be polished, second and third hermetically sealed chambers adjoining the carry-in side and carry-out side, respectively, of the first hermetically sealed chamber, a fluid partition wall device for communicating respective ones of the second and third hermetically sealed chambers with the first hermetically sealed chamber through a fluid curtain capable of being transmitted through the object to be polished, and atmosphere pressure control means for controlling the atmosphere pressure of each of the first, second and third hermetically sealed chambers so that the atmosphere pressure of the first hermetically sealed chamber may become lower than the atmosphere pressure of each of the second and third hermetically sealed chambers.

Another aspect of the present invention provides a precision polishing apparatus having a first unit for making an object to be polished wait temporarily, a second unit provided with polishing means for polishing the object to be polished transported from the first unit, a third unit for washing the object to be polished transported from the second unit, a fourth unit for drying the object to be polished transported from the third unit, hermetically sealing means for individually hermetically sealing the atmospheres of the first to fourth units, and atmosphere pressure control means for controlling the atmosphere pressure of each of the units to a value lower than the outside atmosphere pressure, characterized in that the hermetically sealing means is provided with a fluid partition wall device for communicating at least the first unit and the second unit with each other through a fluid curtain capable of being transmitted through the object to be polished or a liquid tank.

A precision polishing apparatus in which an object to be polished such as a wafer is carried into a hermetically sealed chamber provided with polishing means from a preceding hermetically sealed chamber, and then the object to be polished is conveyed into a succeeding hermetically sealed chamber, controls the atmosphere pressure of each hermetically sealed chamber so that the atmosphere pressure of the hermetically sealed chamber provided with the polishing means may become lower than the pressure of the other hermetically sealed chambers, thereby preventing dust from entering the hermetically sealed chamber preceding or succeeding the hermetically sealed chamber provided with the polishing means.

Also, a hermetically sealed chamber is provided between the units and opening-closing means are designed to be alternately opened, thereby preventing dust from entering from the hermetically sealed chamber provided with the polishing means into the preceding or succeeding unit.

If each opening-closing means is provided with partial opening means for partially opening it and the atmosphere pressure control means is provided with exhaust means for normally exhausting the air from the first hermetically sealed chamber, the clean air or the like around the precision polishing apparatus can be sucked into the first hermetically sealed chamber via the third hermetically sealed chamber and the second hermetically sealed chamber to thereby create a stream of clean air normally flowing toward the first hermetically sealed chamber. Thereby the clean atmosphere in a clean room or the like wherein an exposure apparatus or the like is disposed with the precision polishing apparatus and the second and third hermetically sealed chambers can be reliably prevented from being contaminated by the polishing powder or the like.

It can be avoided for the dust such as the polishing powder to contaminate the device for effecting the pre-process such as the centering and washing of wafers and the atmosphere in the clean room outside it and moreover, the mechanism and control are simple and the automation and speedup of the polishing process can be greatly expedited. Thereby, the running cost and maintenance cost of the precision polishing apparatus can be reduced and also, troubles such as a reduction in the performance of the exposure apparatus or the like in the clean room caused by the polishing powder or the like and the rise of the maintenance cost can be avoided and the throughput of the precision polishing apparatus can be improved to thereby greatly contribute to the lower prices of semiconductor devices or the like.

It can be avoided for the dust such as the polishing powder to contaminate the device for effecting the pre-process such as the centering and washing of wafers and the atmosphere in the clean room outside it. Thereby, the running cost and maintenance cost of the precision polishing apparatus can be reduced and also, troubles such as a reduction in the performance of the exposure apparatus or the like in the clean room caused by the polishing powder or the like and the rise of the maintenance cost can be avoided to thereby greatly contribute to the lower prices of semiconductor devices or the like.

Embodiments of the present invention will now be described with reference to the accompanying drawings, in which:

Fig. 1 is a model view illustrating a precision polishing apparatus according to a first embodiment of the present invention.

Figs. 2A and 2B show portions of the apparatus of Fig. 1, Fig. 2A being an illustration showing a state in which the opening-closing door between a first transporting robot chamber and a wafer stocker unit is opened, and Fig. 2B being an illustration showing a state in which the opening-closing door between the wafer stocker unit and a polishing unit is opened.

Figs. 3A and 3B illustrate methods of pressurizing or reducing the pressure of each hermetically sealed chamber of the apparatus of Figs. 2A and 2B.

Figs. 4A, 4B and 4C show loading units, a transporting robot chamber and a wafer stocker unit according to a second embodiment of the present invention, Fig. 4A being a cross-sectional view illustrating a state in which a cylindrical door is opened to a loading unit, Fig. 4B being a cross-sectional view illustrating a state in which the cylindrical door is being rotated from the state shown in Fig. 4A to the wafer stocker unit side, and Fig. 4C being a cross-sectional view illustrating a state in which the cylindrical door has been opened to the wafer stocker unit side.

Fig. 5 illustrates a case where slits are provided in the cylindrical door.

Fig. 6 is a side view showing the arrangement of the slits in the cylindrical door of Fig. 5.

Fig. 7 is a side view showing a cylindrical door according to a modification in which the arrangement of the slits of Fig. 6 is changed.

Fig. 8 is a developed view showing a cylindrical door according to a modification in which the arrangement of the slits of Fig. 6 is changed as it is developed into a planar state.

Fig. 9 is a model view illustrating a precision polishing apparatus using a fluid partition wall according to a third embodiment of the present invention as opening-closing means.

Figs. 10A and 10B show portions of the apparatus of Fig. 9, Fig. 10A being a fragmentary model cross-sectional view showing a wafer stocker unit to a spin dehydration unit, and Fig. 10B being an enlarged fragmentary cross-sectional view showing the fluid partition wall device on an enlarged scale.

Fig. 11 is a perspective view showing the fluid partition wall device of Figs. 10A and 10B.

Fig. 12 is a fragmentary model cross-sectional view showing the fluid partition wall device according to the third embodiment of the present invention.

Fig. 13 is a fragmentary model cross-sectional view showing another fluid partition wall device according to the third embodiment of the present invention.

Fig. 14 is a fragmentary model cross-sectional view showing another fluid partition wall device according to the third embodiment of the present invention.

Figs. 15A and 15B are model cross-sectional views showing another fluid partition wall device according to the third embodiment of the present invention in two different cross-sections.

Figs. 16A and 16B are enlarged cross-sectional views showing a portion A encircled by the broken line of Fig. 15A and a portion B encircled by the broken line of Fig. 15B on an enlarged scale.

Fig. 17 is a plan view showing a precision polishing apparatus designed by the inventor prior to the present invention.

### First Embodiment

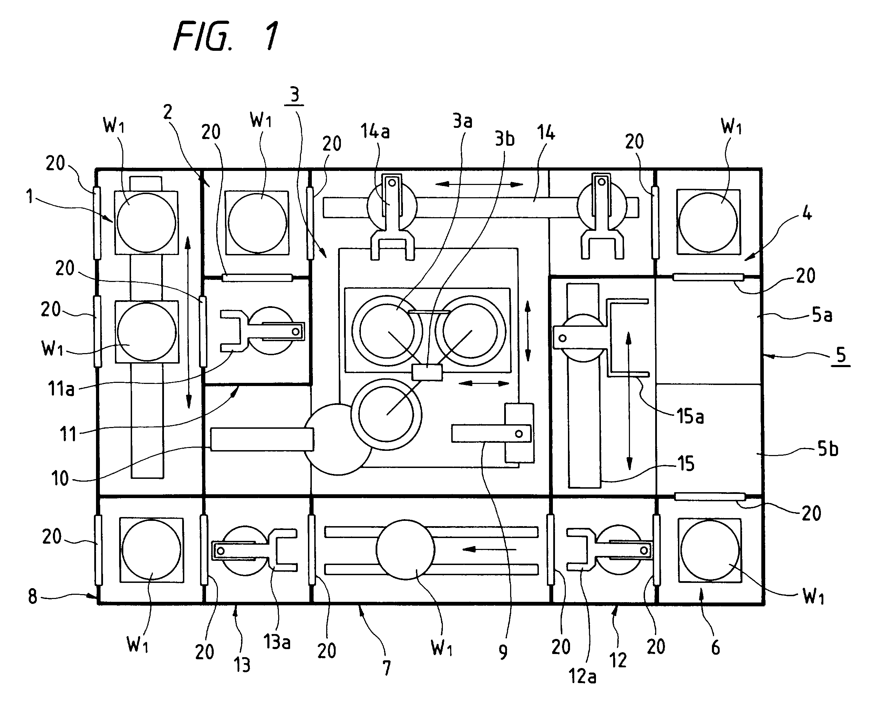

Referring to Fig. 1 which shows a precision polishing apparatus according to a first embodiment of the present invention, this apparatus has a loading unit 1 for receiving at least one wafer W₁ which is an object to be polished bodily with a cassette from a conveyor, not shown, a wafer stocker unit 2 which is a first unit for effecting the centering of the wafer W₁ taken out of the loading unit 1 and making it temporarily wait, a polishing unit 3 which is a second unit for holding the wafer W₁ in such a manner that the polished surface thereof faces upward, and polishing the polished surface of the wafer W₁ by downwardly facing polishing pads 3a which is polishing means while slurry is supplied from a slurry supply device 3b, a pre-washing unit 4 for blowing washing liquid against the wafer W₁ after polished and effect the preliminary washing of the wafer, a washing unit 5 which is a third unit for washing the wafer W₁ by first and second washing tanks 5a and 5b in succession, a spin dehydration unit 6 for rotating the wafer W₁ to thereby remove the washing liquid adhering thereto, a drying unit 7 which is a fourth unit for blowing cold wind or the like against the wafer W₁ to thereby completely dry it, and an unloading unit 8 for sending out the dried wafer W₁ to the next step, and the units 1 to 8 together constitute a hermetically sealed chamber having its interior atmosphere hermetically sealed by hermetically sealing means. The loading unit 1 and the unloading unit 8 are of a construction in which they are disposed on one side of the precision polishing apparatus and an opening-closing door 20 is disposed on the same side. Thereby, it becomes possible to save the space for bringing the object to be polished into and out of the precision polishing apparatus. This is a construction important for the saving of an operator's working space.

The polishing unit 3 is provided with a plurality of downwardly facing polishing pads 3a as previously described, and these polishing pads are alternately reproduced by a hand dresser 9, and when the reproduction is impossible, they are interchanged with new polishing pads by a polishing pad interchanging unit 10. The polishing unit 3 has a downflow mechanism, not shown, which supplies air from the ceiling and exhausts the air from below. The downflow mechanism is for supplying the interior of the polishing unit 3 with a highly clean inert gas such as highly clean air or highly clean nitrogen gas used in a clean room to prevent polishing scraps produced during polishing, slurry particles, organic solvent, etc. from being diffused outside the polishing unit 3. The downflow as it is so called is a flow of gas from above to below, and if there is created such a downflow of gas, the gas supply port may be provided not in the ceiling wall, but in the side wall.

A first transporting robot chamber 11 is provided between the loading unit 1 and the wafer stocker unit 2, and a rotatable type first transporting robot 11a is disposed therein. Likewise, a second transporting robot chamber 12 is provided between the spin dehydration unit 6 and the drying unit 7, and a rotatable type second transporting robot 12a is disposed therein. A third transporting robot chamber 13 is provided between the drying unit 7 and the unloading unit 8, and a rotatable type third transporting robot 13a is disposed therein.

The first to third transporting robot chambers 11 to 13 are hermetically sealed chambers having their interior atmosphere hermetically sealed.

The polishing unit 3 has a fourth transporting robot 14a reciprocally movable along a guide 14, and the washing unit 5 has a washing robot 15a for conveying the wafer W₁ to first and second washing tanks 5a and 5b in succession along a guide 15.

All of the units 1 to 8 and the hermetically sealed chambers such as the transporting robot chambers 11 to 13 are isolated from the atmosphere around the precision polishing apparatus by a partition wall and an opening-closing door which is slide type opening-closing means is disposed between the hermetically sealed chambers adjoining each other, and when each opening-closing door 20 is opened, the atmosphere pressure of the hermetically sealed chambers is controlled as follows by atmosphere pressure control means, not shown.

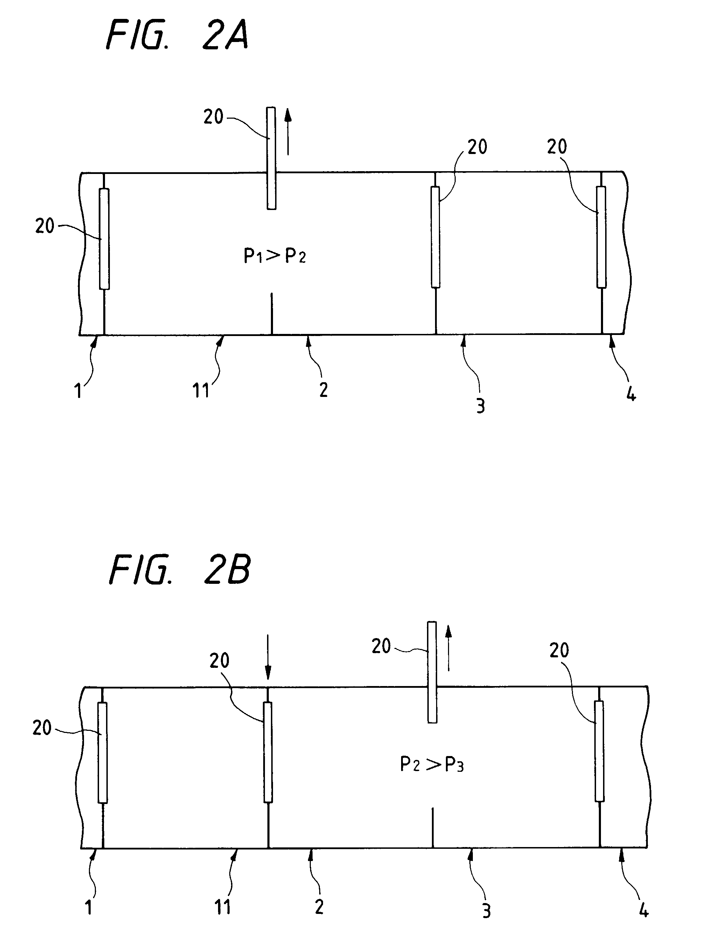

When a wafer, not shown, carried from the loading unit 1 to into the first transporting robot chamber 11 is to be conveyed to the polishing unit 3 via the wafer stocker unit 2, the atmosphere pressure P₂ in the wafer stocker unit 2 is first rendered lower than the atmosphere pressure P₁ in the first transporting robot chamber 11 and the opening-closing door 20 therebetween is opened as shown in Fig. 2A, and the wafer is carried into the wafer stocker unit 2 by the transporting robot lla and the opening-closing door 20 adjacent to the transporting robot chamber 11 is closed. Subsequently, as shown in Fig. 2B, the atmosphere pressure P₂ in the wafer stocker unit 2 is rendered higher than the atmosphere pressure P₃ in the polishing unit 3 and the opening-closing door 20 therebetween is opened to thereby carry the wafer into the polishing unit 3 and polish it.

Also when the wafer is to be carried from the polishing unit 3 into the pre-washing unit 4, the atmosphere pressure in the polishing unit 3 is rendered lower than the atmosphere pressure in the pre-washing unit and the opening-closing door 20 is opened to thereby effect the delivery of the wafer by the fourth transporting robot 14a.

If as described above, the atmosphere pressure in the hermetically sealed chamber farther from the polishing unit 3 is controlled so as to be higher when the opening-closing door 20 of the hermetically sealed chambers adjoining each other is opened, dust such as polishing powder or the like created in the polishing unit 3 can be prevented from entering the wafer stocker unit 2 and the transporting robot chamber 11 or the washing unit 5 or the like in a great deal. As a result, the running cost and maintenance cost of the precision polishing apparatus can be greatly reduced. Also, when the precision polishing apparatus is disposed in a clean room together with an exposure apparatus or the like, the atmosphere in the clean room can be prevented from being contaminated by the polishing powder or the like, and this contributes to the improved performance and reduced maintenance cost of the exposure apparatus or the like.

As regards also the remaining opening-closing door 20 disposed downstream of the polishing unit 3, as described above, the atmosphere pressure in the hermetically sealed chamber farther from the polishing unit 3 is controlled so as to be higher and thereafter, the opening-closing door 20 is opened to effect the delivery of the wafer.

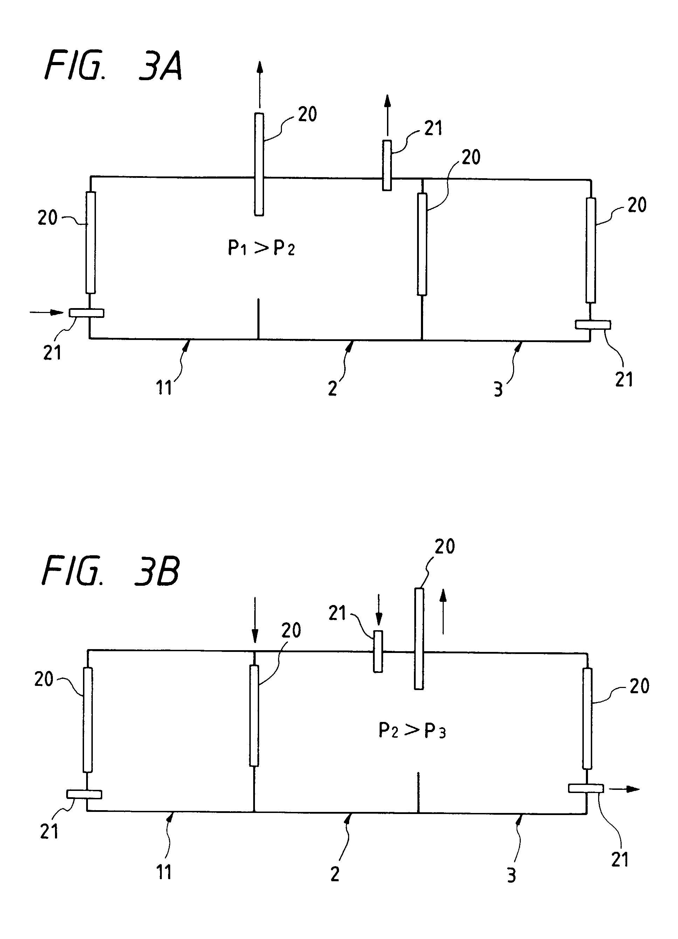

To control the atmosphere pressure in each hermetically sealed chamber, an air supply and exhaust port 21 which is air supply and exhaust means can be provided in each hermetically sealed chamber, as shown in Figs. 3A and 3B, and when the opening-closing door 20 is to be opened, clean air can be supplied from the air supply and exhaust port 21 of one hermetically sealed chamber and air can be exhausted from the air supply and exhaust port 21 of the other hermetically sealed chamber to thereby provide a pressure difference between the atmospheres in the two hermetically sealed chambers, but air can also be supplied to or exhausted from only one hermetically sealed chamber to thereby provide a pressure difference between the atmospheres in the two hermetically sealed chambers.

Also, if a slit opening or the like which is partial opening means is provided in each opening-closing door 20 and air is continuously exhausted from the polishing unit 3 by exhaust means, not shown, the clean air around the precision polishing apparatus is sequentially sucked into each hermetically sealed chamber and there is created an air flow including the clean air, and the atmosphere pressure in each unit becomes lower than the atmosphere pressure around the precision polishing apparatus (the outside atmosphere pressure) and further, there is created a pressure gradient in which the atmosphere pressure is lower in the hermetically sealed chambers nearer to the polishing unit 3. If a state in which the atmosphere pressure is thus higher in the hermetically sealed chambers farther from the polishing unit 3 is normally maintained, it is unnecessary to control the atmosphere pressure in each hermetically sealed chamber each time the opening and closing of the opening-closing door 20 are effected.

### Second Embodiment

A second embodiment is an embodiment in which the opening-closing doors 20 in the first embodiment are replaced by cylindrical doors having transporting robots.

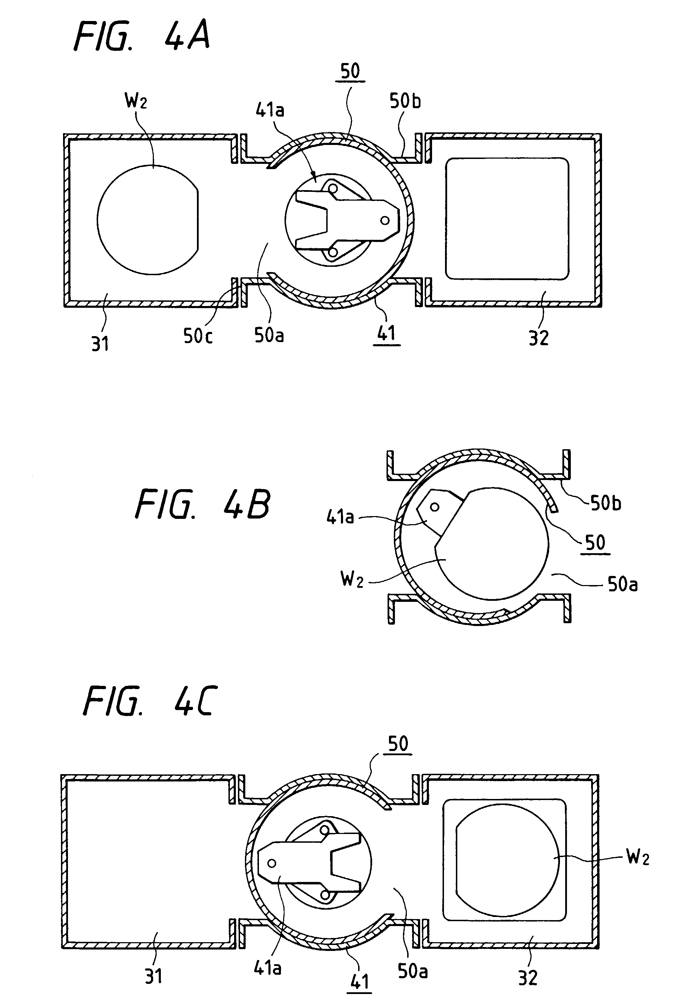

Referring to Figs. 4A to 4C which are model views showing only the loading unit 31, the wafer stocker unit 32 and the first transporting robot chamber 41 of the precision polishing apparatus, the first transporting robot chamber 41 has a rotatable type transporting robot 41a, and instead of the opening-closing door 20, a cylindrical door 50 rotatable in operative association with the rotation of the transporting robot 41a is provided between the loading unit 31 and the wafer stocker unit 32. The cylindrical door 50 is provided with an opening 50a in a portion of the cylindrical partition wall thereof, and is rotatably contained in a casing 50b, and the opposite ends of the casing 50b are fixed to the loading unit 31 and the wafer stocker unit 32 through hermetically sealing members 50c, whereby the transporting robot chamber 41 is formed.

When a wafer W₂ is to be transported, the space between the wafer stocker unit 32 and the transporting robot chamber 41 is first closed by the cylindrical door 50 as shown in Fig. 4A and it is confirmed that the atmosphere pressure in the loading unit 31 and the transporting robot chamber 41 is higher than the atmosphere pressure in the wafer stocker unit 32 and thereafter, as shown in Fig. 4B, the cylindrical door 50 is rotated with the transporting robot 41a, and as shown in Fig. 4C, is stopped at a position in which the opening 50a in the cylindrical 50 door faces the wafer stocker unit 32. Subsequently, the transporting unit 41a is protruded into the wafer stocker unit 32 to thereby effect the delivery of the wafer W₂.

If the rotatable type cylindrical door thus operatively associated with the rotation of the transporting robot is provided in each transporting robot chamber, the drive portion will be simple as compared with a case where a slide type opening-closing door is used to drive it individually from the transporting robot, and it will be unnecessary to control the timing of opening and closing in accord with the driving of the transporting robot. While this cylindrical door is provided between the loading unit 1 and the wafer stocker unit 2 which are shown in Fig. 1, it may be provided between the units as required.

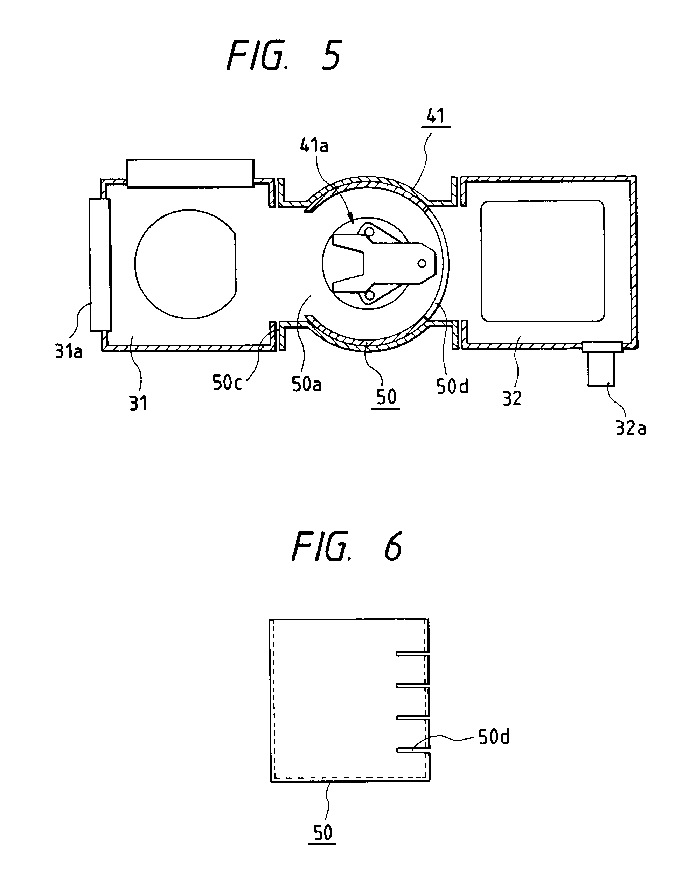

To create the pressure gradient as described above in the atmosphere pressure in the loading unit 31 and the wafer stocker unit 32, there may be adopted a method of providing an air supply and exhaust port and pressurizing means in each hermetically sealed chambers as in Figs. 3A and 3B, or a clean filter 31a may be provided at the entrance of the loading unit 31, as shown in Fig. 5, and the pressure in the wafer stocker unit 32 may be reduced by air exhaust means connected to an exhaust port 32a to thereby clean and introduce the atmosphere around the precision polishing apparatus. In this case, slits 50d are provided in the cylindrical door 50 and the loading unit 31 and the wafer stocker unit 32 are designed to communicate with each other through the slits 50d even when the cylindrical door 50 opens only to the loading unit 31 side or opens only to the wafer stocker unit 32 side. Thereby an air flow is always created from the loading unit 31 toward the wafer stocker unit 32 and the above-mentioned pressure gradient is formed between the two.

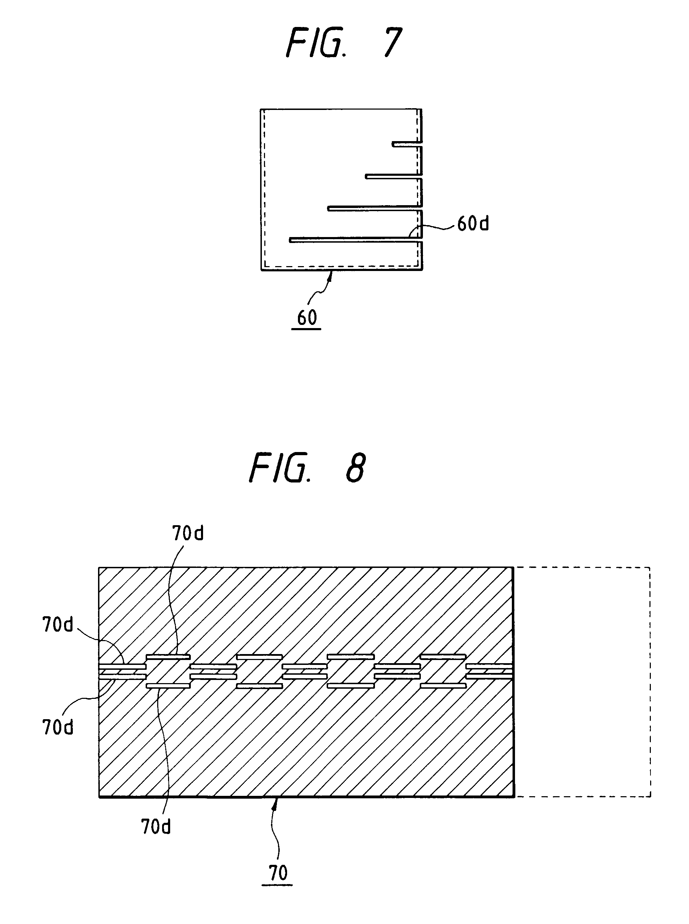

The slits 50d in the cylindrical door 50 may be a plurality of slits extending by the same length in the circumferential direction of the cylindrical door 50, as shown in Fig. 6, or the cylindrical door may be a cylindrical door 60 as shown in Fig. 7 wherein the length of slits 60d is stepwisely varied.

The length and disposition of the slits 50d, 60d of the cylindrical door 50, 60 must be set so that in whatever rotated position the cylindrical door 50, 60 may be, the loading unit 31 and the wafer stocker unit 32 may communicate with each other through at least one of the slits. Generally it is desirable that the opening 50a in the cylindrical door 50 open in the form of a circular arc of 30 to 90 degrees about the center axis of the cylindrical door 50 and each slit 50d extend in the form of a circular arc of 180 degrees or greater. This also holds true of the cylindrical door 60.

Also, use may be made of a cylindrical door 70 as shown in the developed view of Fig. 8 wherein at least one pair of relatively short slits 70d are disposed in the circumferential direction. In this case, respective pairs of slits 70d are provided so that the disposed positions thereof may be stagger for each pair, whereby the hermetically sealed chambers on the opposite sides may normally communicate with each other.

### Third Embodiment

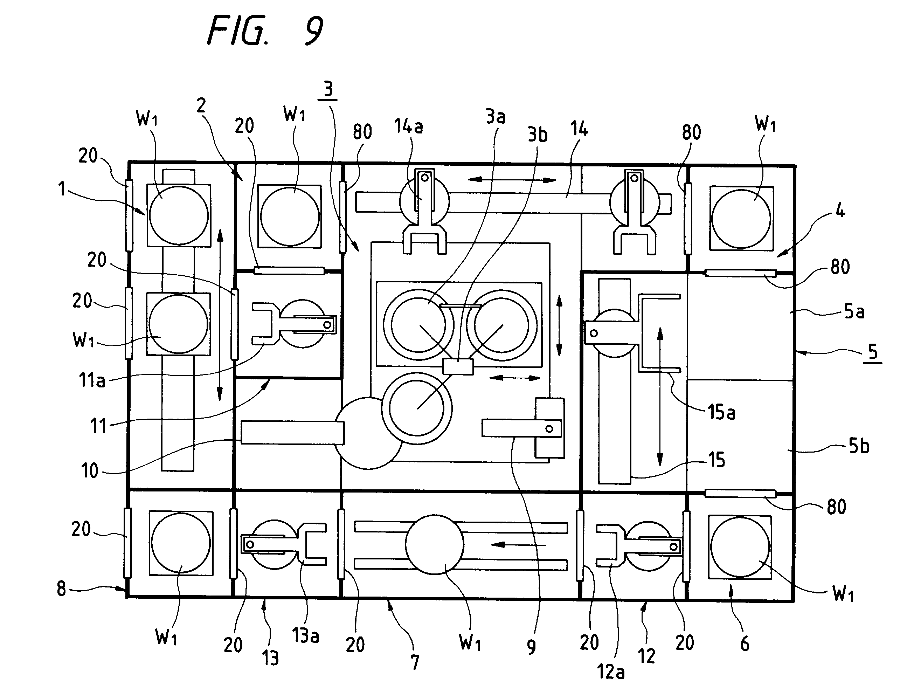

As shown in Fig. 9, a third embodiment is an embodiment in which a first fluid partition wall device 80 as opening-closing means for isolating each hermetically sealed chamber is disposed between the wafer stocker unit 2 and the polishing unit 3, a second fluid partition wall device 80 is disposed between the polishing unit 3 and the pre-washing unit 4, a third fluid partition wall device 80 is disposed between the pre-washing unit 4 and the washing unit 5, and a fourth fluid partition wall device 80 is disposed between the washing unit 5 and the spin dehydration unit 6. The portions among the remaining hermetically sealed chambers, i.e., the portion between the loading unit 1 and the first transporting robot chamber 11 and the portions among the hermetically sealed chambers from the spin dehydration unit 6 to the unloading unit 8 are partitioned by the aforedescribed slide type opening-closing doors 20. Likewise, opening-closing doors 20 are provided at the wafer inlet of the loading unit 1 and the wafer outlet of the unloading unit 8.

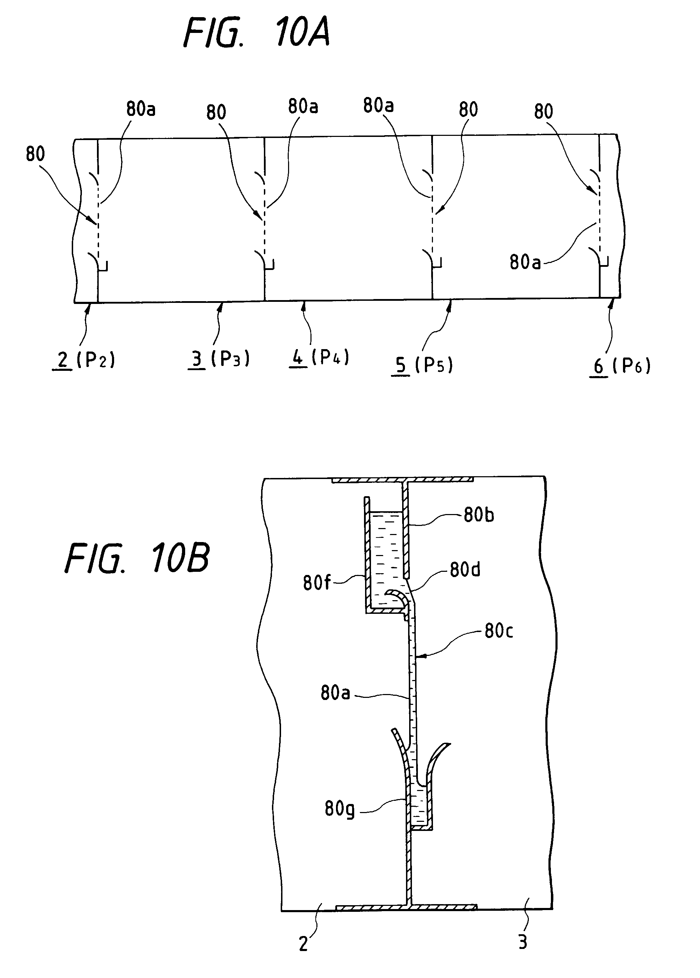

Each fluid partition wall device 80, as shown in Fig. 10A, shuts off the atmosphere in the hermetically sealed chambers adjoining one another (the units 2 to 6) by a water curtain 80a and keeps the air-tightness of each hermetically sealed chamber, and can effect the transportation of the wafer W₁ while maintaining the pressure gradients P₂ > P₃, P₃ < P₄ < P₅ < P₆ in the hermetically sealed chambers 2 to 6 when the pressures in the hermetically sealed chambers 2 to 6 are defined as P₂, P₃, P₄, P₅ and P₆.

Each fluid partition wall device, as shown in Fig. 10B, comprises a partition wall 80b in the hermetically sealed chambers adjoining each other provided with an opening 80c sufficient to carry the wafer W₁ into and out of the hermetically sealed chamber, a slit 80d longer than the width of the opening 80c and disposed above the opening 80c, and water being dropped from the slit 80d to thereby form a water curtain 80a which is a fluid curtain.

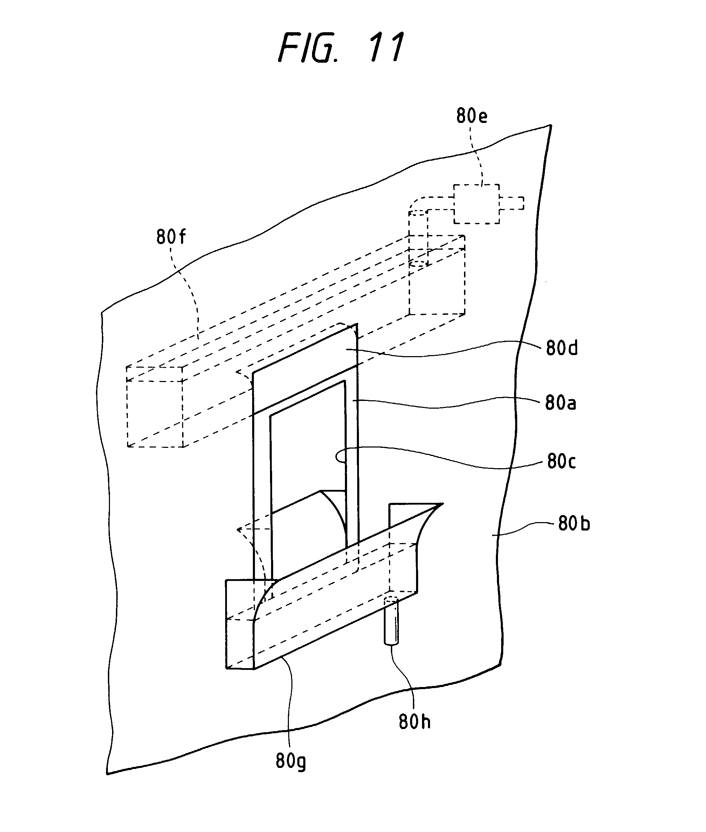

The water supplied to the slit 80d, as shown in Fig. 11, is first stored in an upper reservoir tank 80f via a supply tube having a flow rate control device 80e. The slit 80d opens to the bottom of the upper reservoir tank 80f and can keep the water level in the upper reservoir tank 80f constant to thereby provide a stable quantity of water curtain 80a at all times.

The water falling from the slit 80d becomes a water curtain 80a wider than the width of the opening 80c in the partition wall 80b and covers the opening 80c, and shuts off the atmospheres in the two hermetically sealed chambers. The water collected in a lower reservoir tank 80g is discharged via a drain tube 80h.

When the wafer W₁ is to be transported between adjacent hermetically sealed chambers, for example, when the wafer W₁ to be carried from the wafer stocker unit 2 into the polishing unit 3, the wafer W₁ can simply be moved across the water curtain 80a without requiring the opening-closing operation like that of a slide type opening-closing door. The transportation of the wafer W₁ can be effected almost without spoiling the air-tightness of the two hermetically sealed chambers and moreover, any complicated opening-closing operation or the like is not required at all and therefore, the time spent for the transportation of the wafer W₁ can be shortened and it can be avoided that the apparatus becomes complicated for the driving portion of the opening-closing door or the like.

Thereby, the automation, speedup and lower cost of the precision polishing apparatus can be greatly expedited.

The fact that the wafer becomes wet when it crosses the water curtain exerts no evil influence because the polishing step in the polishing unit and the washing step in the prewashing unit and the washing unit use slurry and liquid such as washing liquid or water. Rather, the so-called pre-wet effect which makes the wafer better fit to the slurry or the like in advance and the advantage that the wafer can be washed by the flow of the water curtain are added.

That is, since the drying step is provided finally, the fact that the wafer becomes wet by the water curtain at the step preceding it does not pose any problem.

While in the present embodiment, the fluid partition wall device 80 by water curtain 80a is disposed between the hermetically sealed chambers leading from the wafer stocker unit 2 to the spin dehydration unit 6, it is of course possible to use the fluid partition wall device 80 instead of the opening-closing door 20 between the remaining hermetically sealed chambers as well if required.

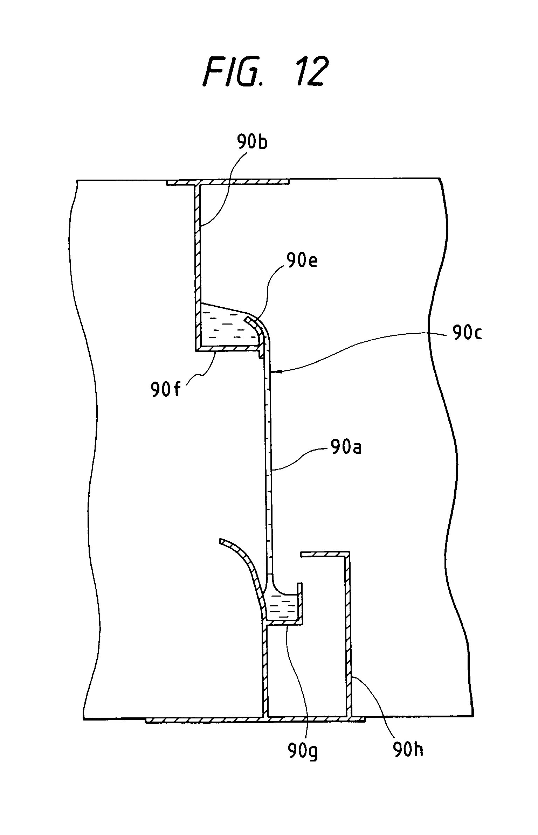

Fig. 12 shows a modification. This provides a liquid reservoir 90f having a weir 90e on the upper end of an opening 90c in a partition wall 90b similar to the partition wall 80b of Fig. 10B, and makes water overflow from the weir 90e to thereby form a water curtain 90a. Preferably a tank 90h may be disposed outside a lower reservoir tank 90g so that a great deal of water can be stored therein.

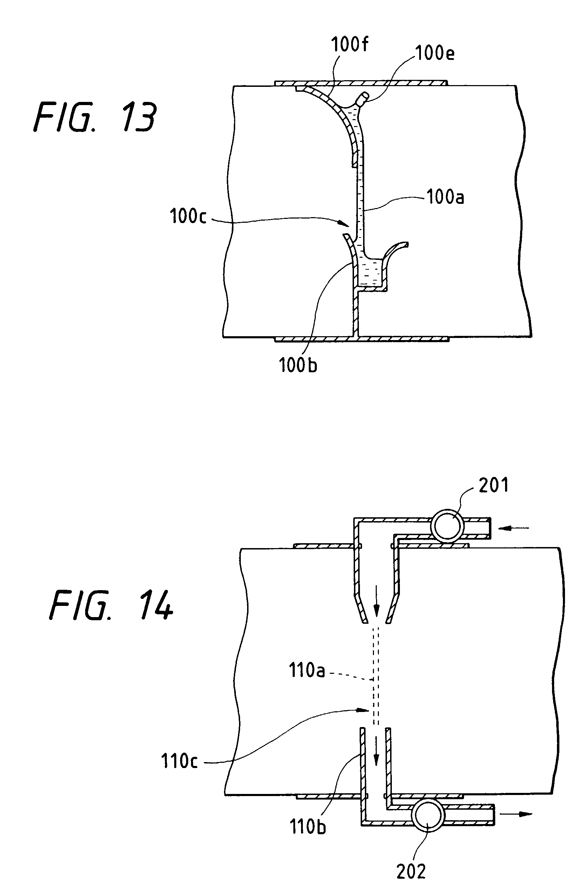

Alternatively, as shown in Fig. 13, the upper portion of an opening 100c in a partition wall 100b may be curved to form a guide wall 100f, and water discharged from a long nozzle 100e may be caused to flow directly along the guide wall 100f to thereby form a water curtain 100a.

Further, as shown in Fig. 14, a conventional air curtain 110a may be provided in an opening 110c in a partition wall 110b between a flower fan 201 and a discharge fan 202. In this case, there is no possibility of the wafer becoming wet and therefore, there is added the advantage that a fluid partition wall device can be used instead of the opening-closing door or the like after the drying step.

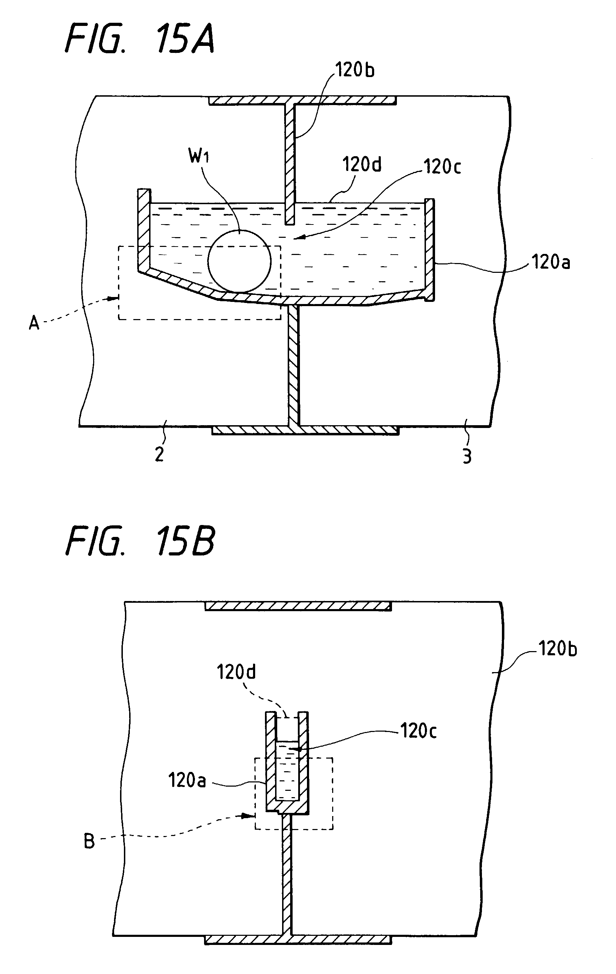

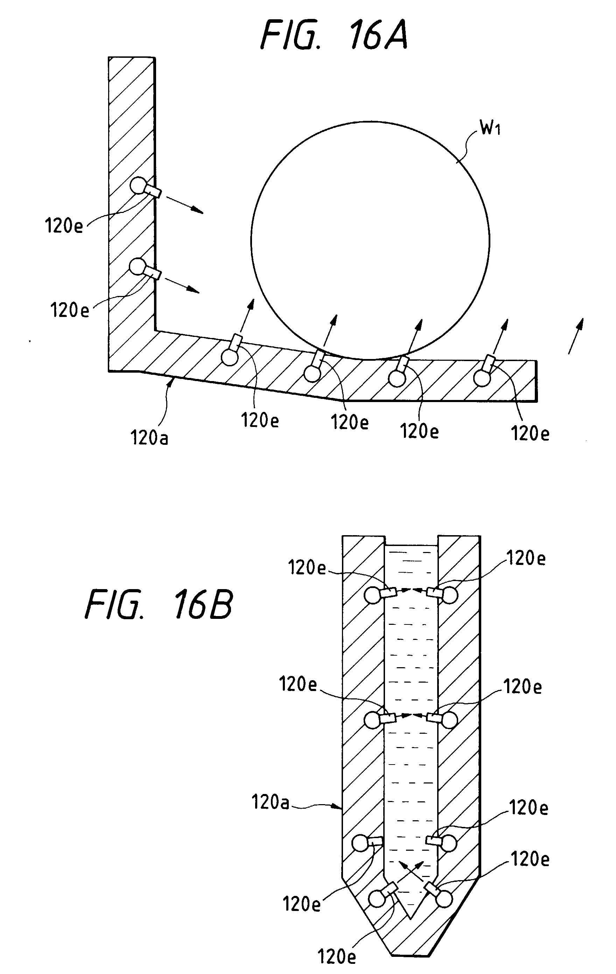

Figs. 15A and 15B show still another modification. This is such that a liquid tank 120a is mounted in the partition wall 120b between two hermetically sealed chambers, for example, the wafer stocker unit 2 and the polishing unit 3, so that the wafer W₁ may be conveyed through the water in the liquid tank 120a. An opening 120c in the partition wall 120b opens below the liquid surface 120d in the liquid tank 120a, and the wafer W₁ thrown into the liquid tank 120a in the wafer stocker unit 2, as shown in Figs. 16A and 16B, is conveyed to the polishing unit side by a water flow discharged from nozzles 120e which are water flow generating means provided in the side wall and bottom wall of the liquid tank 120a.

The nozzles 120e of the liquid tank 120a are disposed inclinedly toward the polishing unit side as shown in Fig. 16A, and discharge water flows toward the both surfaces of the wafer W₁ as shown in Fig. 16B. Also, in the present embodiment, the wafer is conveyed through the interior of the liquid tank 120a and therefore, the liquid is not scattered. Thus, it becomes possible to add a solute capable of removing any unnecessary matter produced in the preceding hermetically sealed chamber to the liquid and as a result the contamination by the unnecessary matter resulting from the conveyance of the wafer can be prevented more effectively. The solute preferable at this time is base such as potassium hydroxide or ammonia which expedites electrostatic repulsion to SiO₂ particles, polishing scraps, highly hydrophobic substances, etc. and removes these from the wafer, or alcohol such as isopropyl alcohol. Also, acid such as hydrochloric acid, sulfuric acid or hydrofluoric acid which oxidized metals, organic matters, etc., neutral, cationic or anionic interfacial active agent or the like which can stably trap SiO₂ particles, polishing scraps, highly hydrophobic substances or the like in water is a preferable solute which can be suitably selected in conformity with a substance to be removed.

Further, an ultrasonic oscillation device (not shown) may be installed in the liquid tank 120a to remove any unnecessary matter from the wafer more effectively.

The present embodiment has the advantage that when the wafer moves between two hermetically sealed chambers, it has no possibility of spoiling the air-tightness of each hermetically sealed chamber. Therefore, in the present embodiment, the portion between the loading unit 1 and the first transporting robot chamber 11 and the portion between adjacent ones of the hermetically sealed chambers from the spin dehydration unit 6 to the unloading unit 8 are partitioned by the aforedescribed slide type opening-closing doors 20 and likewise, opening-closing doors 20 are also provided in the wafer carry-in port of the loading unit 1 and the wafer carry-out port of the unloading unit 8, but if necessary, these may be replaced by the fluid partition wall devices described in the present embodiment.

## Claims

1. A precision polishing apparatus having a first hermetically sealed chamber provided with polishing means, a third hermetically sealed chamber capable of communicating with said first hermetically sealed chamber through a second hermetically sealed chamber, first and second opening-closing means for alternately communicating said first and said third hermetically sealed chamber with said second hermetically sealed chamber, and atmosphere pressure control means for controlling the atmosphere pressure of said first and said second hermetically sealed chamber so that the atmosphere pressure of said first hermetically sealed chamber may become lower than the atmosphere pressure of said second hermetically sealed chamber when at least said first opening-closing means is opened.

2. A precision polishing apparatus according to Claim 1, characterized in that said atmosphere pressure control means is designed to control the atmosphere pressure of said second and said third hermetically sealed chamber so that the atmosphere pressure of said second hermetically sealed chamber may become lower than the atmosphere pressure of said third hermetically sealed chamber when said second opening-closing means is opened.

3. A precision polishing apparatus according to Claim 1 or 2, characterized in that said atmosphere pressure control means is provided with air supply and exhaust means for individually controlling the atmosphere pressure of each of said hermetically sealed chambers.

4. A precision polishing apparatus according to Claim 1 or 2, characterized in that each of said opening-closing means is provided with partial opening means for partially opening it, and said atmosphere pressure control means is provided with exhaust means for normally exhausting the air of said first hermetically sealed chamber.

5. A precision polishing apparatus according to Claim 1, characterized in that each of said opening-closing means is a slide type opening-closing door.

6. A precision polishing apparatus according to Claim 1, characterized in that a transporting robot for transporting an object to be polished between adjacent ones of said hermetically sealed chambers is provided, and said first and second opening-closing means each are comprised of a rotatable type cylindrical door adapted to be opened and closed in operative association with said transporting robot.

7. A precision polishing apparatus according to Claim 1, characterized in that said transporting robot is disposed in said second or said third hermetically sealed chamber.

8. A precision polishing apparatus according to Claim 1, characterized in that said first hermetically sealed chamber has a downflow mechanism for blowing clean air downwardly from above.

9. A precision polishing apparatus according to Claim 1, characterized by having a loading unit and an unloading unit on a side of said precision polishing apparatus.

10. A precision polishing method of precision-polishing an object to be polished by a precision polishing apparatus having a first hermetically sealed chamber provided with polishing means, a third hermetically sealed chamber capable of communicating with said first hermetically sealed chamber through a second hermetically sealed chamber, first and second opening-closing means for alternately communicating said first and said third hermetically sealed chamber with said second hermetically sealed chamber, and atmosphere pressure control means for controlling the atmosphere pressure of said first and said second hermetically sealed chamber so that the atmosphere pressure of said first hermetically sealed chamber may become lower than the atmosphere pressure of said second hermetically sealed chamber when at least said first opening-closing means is opened.

11. A precision polishing method according to Claim 10, characterized in that said object to be polished is a semiconductor.

12. A precision polishing method according to Claim 10, characterized in that said object to be polished has a surface to be polished having insulating film and/or metallic film formed thereon.

13. A precision polishing method according to Claim 10, characterized in that said object to be polished is an insulative substrate having semiconductor film formed thereon.

14. A precision polishing apparatus having a first hermetically sealed chamber provided with polishing means, a second hermetically sealed chamber, opening-closing means for communicating said first and said second hermetically sealed chamber with each other, and atmosphere pressure control means for controlling the atmosphere pressure of said first and said second hermetically sealed chamber so that the atmosphere pressure of said first hermetically sealed chamber may become lower than the atmosphere pressure of said second hermetically sealed chamber when said opening-closing means is opened, characterized in that said first hermetically sealed chamber has a downflow mechanism for blowing clean air downwardly from above.

15. A precision polishing apparatus according to Claim 14, characterized in that said atmosphere pressure control means is provided with air supply and exhaust means for individually controlling the atmosphere pressure of each of said hermetically sealed chambers.

16. A precision polishing apparatus according to Claim 14, characterized in that said opening-closing means is provided with partial opening means for partially opening it, and said atmosphere pressure control means is provided with exhaust means for normally exhausting the air from said first hermetically sealed chamber.

17. A precision polishing apparatus according to any one of Claims 14 to 16, characterized in that said opening-closing means is a slide type opening-closing door.

18. A precision polishing apparatus according to any one of Claims 14 to 16, characterized in that a transporting robot for transporting an object to be polished between said hermetically sealed chambers is provided, and said opening-closing means is comprised of a rotatable type cylindrical door adapted to be opened and closed in operative association with said transporting robot.

19. A precision polishing apparatus according to Claim 14, characterized in that said transporting robot is disposed in said first or said second hermetically sealed chamber.

20. A precision polishing apparatus having a first unit for making an object to be polished wait temporarily, a second unit provided with polishing means for polishing the object to be polished transported from said first unit, a third unit for washing the object to be polished transported from said second unit, a fourth unit for drying the object to be polished transported from said third unit, hermetically sealing means for individually hermetically sealing the atmospheres of said first to fourth units, and atmosphere pressure control means for controlling the atmosphere pressure of each of said units to a value lower than the outside atmosphere pressure.

21. A precision polishing apparatus according to Claim 20, characterized in that said atmosphere pressure control means is designed to create a pressure gradient decreasing from said first unit toward said second unit and a pressure gradient decreasing from said fourth unit toward said second unit via said third unit.

22. A precision polishing apparatus according to Claim 20 or 21, characterized in that said atmosphere pressure control means is designed to create an air flow of clean air flowing from said first unit toward said second unit and an air flow of clean air flowing from said fourth unit toward said second unit via said third unit.

23. A precision polishing apparatus according to Claim 20, characterized in that a transporting robot for transporting said object to be polished is disposed between adjacent ones of said units.

24. A precision polishing apparatus having a first hermetically sealed chamber provided with polishing means for polishing an object to be polished, second and third hermetically sealed chambers adjoining the carry-in side and carry-out side, respectively, of said first hermetically sealed chamber, a fluid partition wall device for communicating respective ones of said second and third hermetically sealed chambers with said first hermetically sealed chamber through a fluid curtain capable of being transmitted through said object to be polished, and atmosphere pressure control means for controlling the atmosphere pressure of each of said first, second and third hermetically sealed chambers so that the atmosphere pressure of said first hermetically sealed chamber may become lower than the atmosphere pressure of each of said second and third hermetically sealed chambers.

25. A precision polishing apparatus according to Claim 24, characterized in that said fluid curtain is a water curtain.

26. A precision polishing apparatus according to Claim 24, characterized in that a liquid tank capable of moving said object to be polished as it is immersed therein is used instead of said fluid curtain.

27. A precision polishing apparatus according to Claim 26, characterized in that one of an acid substance, a basic substance and an alcohol interfacial active agent is dissolved in the liquid in said liquid tank.

28. A precision polishing apparatus according to Claim 26, characterized in that said liquid tank has water flow generating means for generating a water flow for moving said object to be polished.

29. A precision polishing apparatus having a first unit for making an object to be polished wait temporarily, a second unit provided with polishing means for polishing the object to be polished transported from said first unit, a third unit for washing the object to be polished transported from said second unit, a fourth unit for drying the object to be polished transported from said third unit, hermetically sealing means for individually hermetically sealing the atmospheres of said first to fourth units, and atmosphere pressure control means for controlling the atmosphere pressure of each of said units to a value lower than the outside atmosphere pressure,
characterized in that said hermetically sealing means is provided with a fluid partition wall device for communicating at least said first unit and said second unit with each other through a fluid curtain capable of being transmitted through said object to be polished or a liquid tank.

30. A precision polishing apparatus according to Claim 29, characterized in that said atmosphere pressure control means is designed to create a pressure gradient decreasing from said first unit toward said second unit and a pressure gradient decreasing from said fourth unit toward said second unit via said third unit.

31. A precision polishing apparatus according to Claim 29 or 30, characterized by the provision of a loading unit provided on a side of said precision polishing apparatus for carrying said object to be polished into said precision polishing apparatus, and an unloading unit for carrying out said object to be polished from said precision polishing apparatus.

32. A precision polishing apparatus according to Claim 2, characterized in that each of said opening-closing means is a slide type opening-closing door.

33. A precision polishing apparatus according to Claim 3, characterized in that each of said opening-closing means is a slide type opening-closing door.

34. A precision polishing apparatus according to Claim 4, characterized in that each of said opening-closing means is a slide type opening-closing door.

35. A precision polishing apparatus according to Claim 2, characterized in that a transporting robot for transporting an object to be polished between adjacent ones of said hermetically sealed chambers is provided, and said first and second opening-closing means each are comprised of a rotatable type cylindrical door adapted to be opened and closed in operative association with said transporting robot.

36. A precision polishing apparatus according to Claim 3, characterized in that a transporting robot for transporting an object to be polished between adjacent ones of said hermetically sealed chambers is provided, and said first and second opening-closing means each are comprised of a rotatable type cylindrical door adapted to be opened and closed in operative association with said transporting robot.

37. A precision polishing apparatus according to Claim 4, characterized in that a transporting robot for transporting an object to be polished between adjacent ones of said hermetically sealed chambers is provided, and said first and second opening-closing means each are comprised of a rotatable type cylindrical door adapted to be opened and closed in operative association with said transporting robot.

38. A precision polishing apparatus according to Claim 2, characterized in that said transporting robot is disposed in said second or said third hermetically sealed chamber.

39. A precision polishing apparatus according to Claim 3, characterized in that said transporting robot is disposed in said second or said third hermetically sealed chamber.

40. A precision polishing apparatus according to Claim 4, characterized in that said transporting robot is disposed in said second or said third hermetically sealed chamber.

41. A precision polishing apparatus according to Claim 5, characterized in that said transporting robot is disposed in said second or said third hermetically sealed chamber.

42. A precision polishing apparatus according to Claim 6, characterized in that said transporting robot is disposed in said second or said third hermetically sealed chamber.

43. A precision polishing apparatus according to Claim 2, characterized in that said first hermetically sealed chamber has a downflow mechanism for blowing clean air downwardly from above.

44. A precision polishing apparatus according to Claim 3, characterized in that said first hermetically sealed chamber has a downflow mechanism for blowing clean air downwardly from above.

45. A precision polishing apparatus according to Claim 4, characterized in that said first hermetically sealed chamber has a downflow mechanism for blowing clean air downwardly from above.

46. A precision polishing apparatus according to Claim 5, characterized in that said first hermetically sealed chamber has a downflow mechanism for blowing clean air downwardly from above.

47. A precision polishing apparatus according to Claim 6, characterized in that said first hermetically sealed chamber has a downflow mechanism for blowing clean air downwardly from above.

48. A precision polishing apparatus according to Claim 7, characterized in that said first hermetically sealed chamber has a downflow mechanism for blowing clean air downwardly from above.

49. A precision polishing apparatus according to Claim 2, characterized by having a loading unit and an unloading unit on a side of said precision polishing apparatus.

50. A precision polishing apparatus according to Claim 3, characterized by having a loading unit and an unloading unit on a side of said precision polishing apparatus.

51. A precision polishing apparatus according to Claim 4, characterized by having a loading unit and an unloading unit on a side of said precision polishing apparatus.

52. A precision polishing apparatus according to Claim 5, characterized by having a loading unit and an unloading unit on a side of said precision polishing apparatus.

53. A precision polishing apparatus according to Claim 6, characterized by having a loading unit and an unloading unit on a side of said precision polishing apparatus.

54. A precision polishing apparatus according to Claim 7, characterized by having a loading unit and an unloading unit on a side of said precision polishing apparatus.

55. A precision polishing apparatus according to Claim 8, characterized by having a loading unit and an unloading unit on a side of said precision polishing apparatus.

56. A precision polishing apparatus according to Claim 15, characterized in that said transporting robot is disposed in said first or said second hermetically sealed chamber.

57. A precision polishing apparatus according to Claim 16, characterized in that said transporting robot is disposed in said first or said second hermetically sealed chamber.

58. A precision polishing apparatus according to Claim 17, characterized in that said transporting robot is disposed in said first or said second hermetically sealed chamber.

59. A precision polishing apparatus according to Claim 18, characterized in that said transporting robot is disposed in said first or said second hermetically sealed chamber.

60. A precision polishing apparatus according to claim 21, characterized in that a transporting robot for transporting said object to be polished is disposed between adjacent ones of said units.

61. A precision polishing apparatus according to claim 22, characterized in that a transporting robot for transporting said object to be polished is disposed between adjacent ones of said units.

62. Polishing apparatus comprising a first sealed chamber containing polishing means, a second sealed chamber, a port between said first and second sealed chambers which is capable of being opened and closed, and pressure control means for controlling the pressure in at least said first sealed chamber so that the pressure in said first sealed chamber is lower than the pressure in said second sealed chamber.

63. Polishing apparatus according to claim 62 including a third sealed chamber and a second port between said first and third sealed chambers which is capable of being opened and closed, wherein said pressure control means is adapted to control the pressure in at least said first sealed chamber so that the pressure in said first sealed chamber is lower than the pressure in said third sealed chamber .

64. Polishing apparatus according to claim 63 wherein a fluid curtain is provided at each of said ports between the sealed chamber.

65. Polishing apparatus according to claim 62 including a third sealed chamber, a second port between said second and third sealed chambers which is capable of being opened and closed, and port control means for controlling said ports to open alternately.

66. Polishing apparatus according to any one of claims 62 to 65 wherein said first sealed chamber includes air flow means for blowing clean air into said first sealed chamber.

67. Polishing apparatus comprising a first sealed chamber containing polishing means, a second sealed chamber containing means for receiving an object to be polished from outside, and passing said object into said first sealed chamber for polishing, and pressure control means for controlling the pressure in said sealed chambers to be lower than ambient atmospheric pressure.

68. Polishing apparatus according to claim 67 including a third sealed chamber containing washing means for washing a polished object received from said first sealed chamber, and a fourth sealed chamber containing means for drying said object after washing, said pressure control means being adapted to control the pressure in all said sealed chambers to be lower than ambient atmospheric pressure.
